# EUROPEAN PATENT APPLICATION

(11) **EP 4 819 823 A2**
(43) Date of publication of application: **07.10.2026**
(21) Application number: 26167217.4
(22) Date of filing: 24.03.2026
(51) Int. Cl.: H10W 40/20, H10W 40/25, H10W 40/60, H10W 40/00

(54) **ELECTRONIC DEVICE INCLUDING INSULATION PLATE COVER**

(30) Priority: 04.04.2025 KR 20250043878; 07.04.2025 KR 20250044584
(71) Applicant: LG Innotek Co., Ltd., Seoul 07796 (KR)
(72) Inventor: JEON, Ji Hwan, 07796 Seoul (KR); JUNG, Tae Bok, 07796 Seoul (KR)
(74) Representative: Plasseraud IP

(57) **Abstract**

The present invention relates to an electronic device comprising a novel insulation plate cover and a grounding piece.

The electronic device including the insulation plate cover comprises a plate-shaped insulation plate in contact with a semiconductor element, a heat sink protruding in a planar manner and including a protrusion in contact with the insulation plate, and an insulation plate cover coupling the insulation plate and the heat sink. The insulation plate cover may include a hollow frame, a first wall formed inside the frame to surround sides of the protrusion of the heat sink, and a second wall formed outside the frame to surround sides of the insulation plate.

The electronic device including the grounding piece comprises a case, a mounting body formed of a conductive metal and protruding in a planar manner from the case, and a grounding piece assembled on the mounting body with a bolt. The mounting body may include a mounting groove concavely recessed on a top surface and a tab hole for receiving the bolt.

## Description

### [Field of the Invention]

The present invention relates to an electronic device including an insulation plate cover and a grounding piece of a new structure.

### [Background of the Related Art]

With recent demands for improved performance and miniaturization of electronic devices, increased mounting density of components and enhanced performance thereof have been required.

In particular, for electric vehicle charging devices, due to their product characteristics requiring a large number of power semiconductor elements, it has become an important factor in product competitiveness to both effectively dissipate heat generated from such power semiconductor elements and implement such a heat dissipation structure in a compact size. That is, there is a need for an electric vehicle charging device that can implement a heat dissipation structure at low manufacturing cost while simultaneously securing the insulation distances required by safety standards.

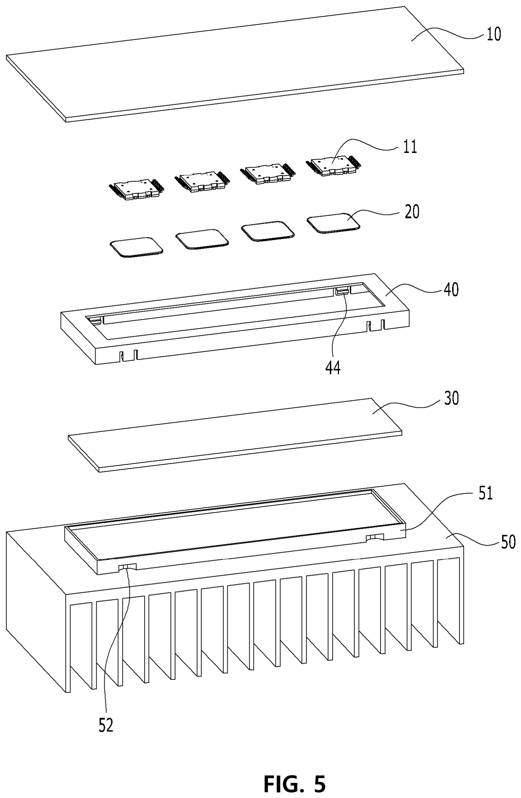

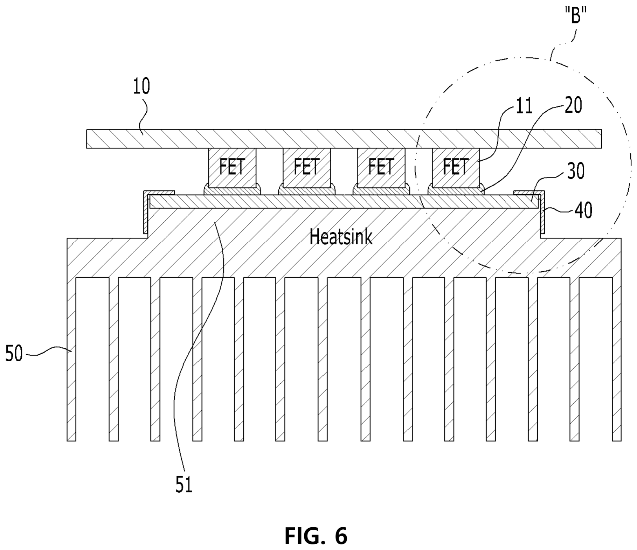

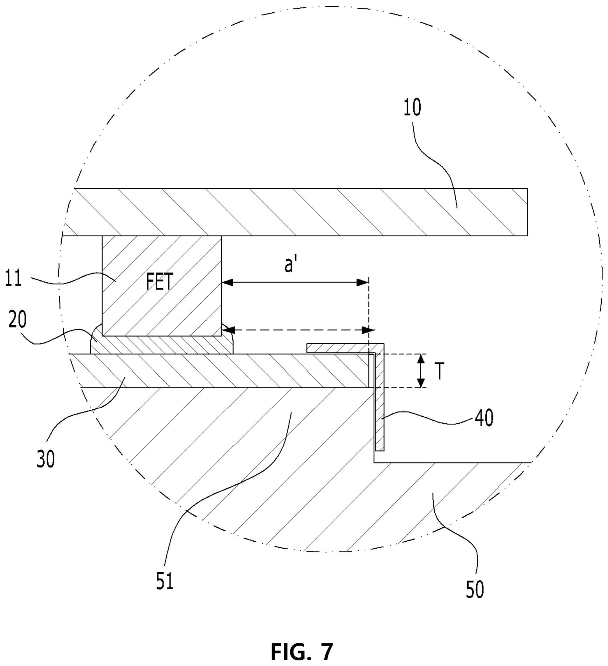

Figures 5 and 6 are an exploded perspective view and a cross-sectional view illustrating an electronic device including a conventional insulation plate cover respectively, and Figure 7 is an enlarged cross-sectional view of portion "B" of Figure 6.

Referring to Figures 5 and 6, a semiconductor element 11 mounted on a circuit board 10 is a heat-generating component and dissipates heat by contacting a heat sink 50. However, in order to secure an insulation distance required by safety standards, an insulation plate 30 is inserted between the semiconductor element 11 and the heat sink 50. In this case, an insulation plate cover 40 is used to fix the insulation plate 30 on a protrusion part 51. That is, the insulation plate 30 is placed on the protrusion part 51, and a first hook 44 of the insulation plate cover 40 is engaged with a hook catch 52 formed on a side surface of the protrusion part 51, thereby fixing the insulation plate 30 to the protrusion part 51.

Referring to Figure 7, a distance a' between the heat sink 50 and the semiconductor element 11 must satisfy an insulation distance required by safety standards. That is, the size of the insulation plate 30 must be increased such that a distance from an outer edge of the semiconductor element 11 to the heat sink 50 is ensured to be at least a'.

In general, since the insulation plate 30 is expensive, the manufacturing cost of an electronic device including an enlarged insulation plate 30 for securing the insulation distance increases, and the enlarged insulation plate 30 also imposes constraints on utilization of internal space of the electronic device.

Meanwhile, a grounding structure for the chassis of an electronic device is required to prevent electric shock accidents in the event that leakage current flows through the electronic device due to insulation failure of internal wiring or circuit components, or when insulation breakdown occurs due to electrical shocks such as lightning.

In general, an electronic device to which wires for transmitting power or electrical signals are connected is provided with grounding in order to prevent electric shock accidents and various failures caused by leakage currents, and to directly discharge unexpectedly generated excess charges, such as those caused by lightning, to the ground, thereby preventing the charges from causing damage to buildings or people through other paths.

In the case of an electric vehicle charging apparatus, a large number of power semiconductor elements and related components are employed to convert high voltage and large current, and since the apparatus is mainly installed outdoors, the grounding structure is an important factor for ensuring the safety of users and installers. In particular, when a case forming the exterior of the apparatus is made of a metal material, grounding of the case is even more important because users frequently come into contact with the case.

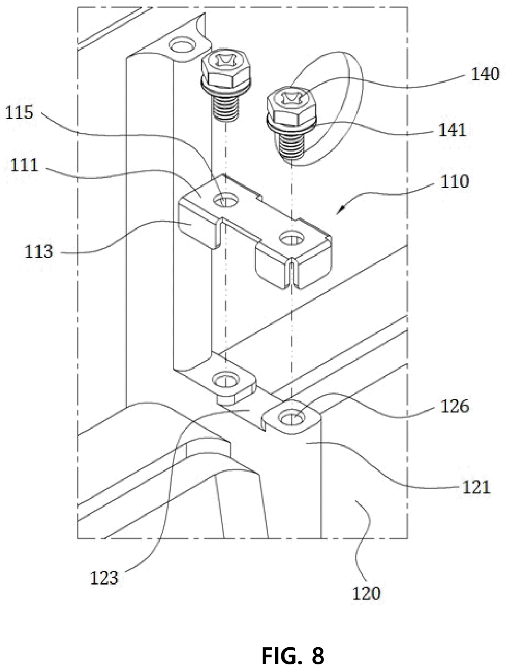

Figure 8 is a view illustrating a conventional grounding structure.

Referring to Figure 8, a grounding piece 10 formed of a conductive metal is fixed to a case 20 formed of a metal material by a bolt 40.

A plurality of through-holes through which a copper wire 30 passes are formed in the grounding piece 10 in a horizontal direction, and a plurality of threaded holes into which move bolts 45 will be inserted are formed in a vertical direction such that each move bolt 45 can close or open each through-hole.

When the cover of the grounding wire 135 is peeled off and the exposed copper wire 130 is inserted into the through-hole, and the move bolt 145 is inserted into the threaded hole and tightened, the copper wire 130 is circuitically connected to the grounding piece 110 so that the grounding wire 135 may be electrically connected to the case 120.

However, in order to implement such a grounding structure, a grounding piece must be prepared in advance by machining a metal material into a complex shape and then mounted to the electronic device, which increases the manufacturing cost of the device.

Accordingly, the present invention proposes an electronic device including an insulation plate having an improved heat dissipation structure and a simplified grounding structure, thereby addressing the above-described problems.

### [Technical problem]

The technical problem to be solved by the present invention to reduce the size of an insulation plate installed to secure an insulation distance, while still satisfying the insulation distance required by safety standards of various countries.

Another technical problem to be solved by the present invention is to efficiently implement a grounding structure that allows leakage current to safely flow to ground in the event of a ground fault, while keeping manufacturing costs low.

The technical problems of the present invention are not limited to the technical problems described above, and other technical problems not explicitly mentioned will be clearly understood by those skilled in the art from the following description.

### [Technical solution]

An electronic device according to the present invention for solving the above technical problem, as an electronic device including an insulation plate cover for a heat dissipation structure that dissipates heat generated from a semiconductor element, the electronic device may include an insulation plate in contact with the semiconductor element, a heat sink including a protrusion part protruding in a planar manner and in contact with the insulation plate, and an insulation plate cover coupling the insulation plate and the heat sink.

The insulation plate cover may include a hollow frame, a first wall formed on inner side of the frame to surround sides of the protrusion part of the heat sink, and a second wall formed on outer side of the frame to surround sides of the insulation plate.

In some embodiments of the present invention, the insulation plate cover may further comprise a plurality of first hooks formed at sections where part of the first wall is open, and configured to be engaged with and fixed to a side surface of the protrusion part, and a plurality of second hooks formed at sections where part of the second wall is open, and configured to be engaged with and fixed to an upper surface of the insulation plate.

In some embodiments of the present invention, a height of the first wall may be smaller than a height of the protrusion part.

In some embodiments of the present invention, a length of the first hook up to its distal end may be smaller than a height of the protrusion part.

In some embodiments of the present invention, the protrusion part may include a hook catch that is recessed inwardly on a side surface thereof.

In some embodiments of the present invention, an insulation distance between the semiconductor element and the heat sink may be a sum of a distance from the semiconductor element to an outer edge of the insulation plate, a thickness of the insulation plate, and a distance from the outer edge of the insulation plate to an outer edge of the protrusion part.

In some embodiments of the present invention, the insulation plate may be formed of an aluminum oxide Al₂O₃ ceramic plate.

In some embodiments of the present invention, a thermal paste as a thermal interface material may be additionally disposed between the semiconductor element and the insulation plate.

According to the present invention for solving the above technical problems, an electronic device including a grounding piece may include a case, a mounting body formed of a conductive metal and protruding from the case, and a grounding piece assembled on the mounting body with a bolt.

The mounting body may include a mounting groove recessed concavely in an upper surface thereof and a tap-hole into which the bolt is assembled, the grounding piece may include a flat plate contacting the upper surface of the mounting body and a bolt hole through which the bolt passes, when the mounting body and the grounding piece are assembled, an insertion opening into which a copper wire is inserted is defined by the mounting groove and the flat plate, and a height of the insertion opening may be smaller than a diameter of the copper wire.

In some embodiments of the present invention, the mounting body may be integrally formed with the metal case.

In some embodiments of the present invention, the grounding piece may further include a side reinforcement contacting a side of the mounting body, and the side reinforcement is not provided on a side of the mounting groove.

In some embodiments of the present invention, a ground mark may be engraved on a top surface of the flat plate.

In some embodiments of the present invention, a washer for preventing loosening may be further provided between the bolt and the grounding piece.

In some embodiments of the present invention, two or more copper wires may be mounted on the mounting groove.

In some embodiments of the present invention, the copper wires may have different diameters from each other.

In some embodiments of the present invention, the mounting body may be a separate component, machined independently and assembled onto the plastic case.

In some embodiments of the present invention, the mounting body may further include a through-hole for receiving a screw.

In some embodiments of the present invention, the grounding piece may further include a relief hole configured to accommodate a head of the screw.

### [Effects of the invention]

According to the electronic device including the insulation plate cover of the present invention, it is possible to satisfy the insulation distance required by safety standards while reducing the size of the insulation plate installed to provide insulation between the heat sink and the heat-generating element. By reducing the size of the expensive insulation plate, the manufacturing cost of the electronic device can be lowered, and the utilization efficiency of the internal space of the electronic device can be improved.

In addition, according to the electronic device including the grounding piece of the present invention, the same grounding-wire connection effect as that of conventional grounding structures can be achieved with a reduced number of machining steps compared to conventional grounding components, thereby reducing the manufacturing cost of the device employing the same. In particular, by forming a part of the grounding structure using the case of the electronic device, a greater reduction in manufacturing cost can be achieved.

### [Brief Description of the Drawings]

**FIG. 1** is an exploded perspective view illustrating an electronic device including an insulation plate cover according to an embodiment of the present invention.
**FIG. 2** is a cross-sectional view illustrating an electronic device including an insulation plate cover according to an embodiment of the present invention.
**FIG. 3** is an enlarged cross-sectional view of portion "A" of FIG. 2.
**FIG. 4** is a perspective view illustrating an insulation plate cover according to an embodiment of the present invention.
**FIG. 5** is an exploded perspective view illustrating a conventional electronic device including an insulation plate cover.
**FIG. 6** is a cross-sectional view illustrating a conventional electronic device including an insulation plate cover.
**FIG. 7** is an enlarged cross-sectional view of portion "B" of FIG. 6.
**FIG. 8** is an exploded perspective view illustrating an electronic device including a grounding piece according to a first embodiment of the present invention.
**FIG. 9** is a cross-sectional view illustrating an electronic device including a grounding piece according to the first embodiment of the present invention.
**FIG. 10** is an exploded perspective view illustrating an electronic device including a grounding piece according to a second embodiment of the present invention.
**FIG. 11** is a cross-sectional view illustrating an electronic device including a grounding piece according to the second embodiment of the present invention.
**FIG. 12** is a cross-sectional view illustrating an electronic device including a grounding piece according to a third embodiment of the present invention.
**FIG. 13** is an exploded perspective view illustrating an electronic device including a grounding piece according to a fourth embodiment of the present invention.
**FIG. 14** is a cross-sectional view illustrating an electronic device including a grounding piece according to the fourth embodiment of the present invention.

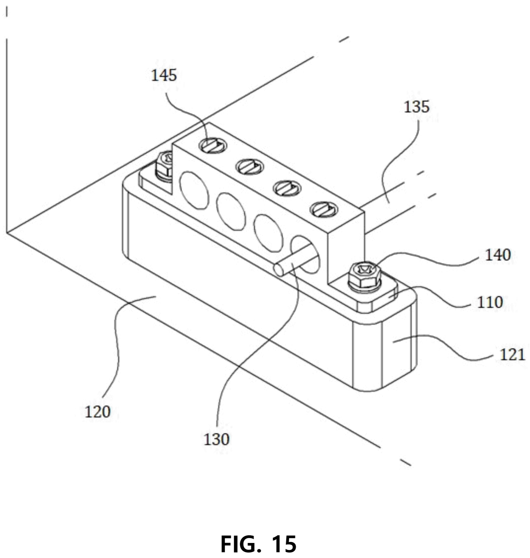

**FIG. 15** is a view illustrating a conventional grounding structure.

### [Embodiments of the invention]

The advantages and features of the present invention and the method for achieving them will become clear by referring to the embodiments described below in detail together with the accompanying drawings. However, the present invention is not limited to the embodiments disclosed below and will be implemented in various different forms. These embodiments are provided only to make the disclosure of the present invention complete and to fully inform those skilled in the art of the scope of the present invention, and the present invention is only defined by the scope of the claims. Like reference numerals refer to like elements throughout the specification.

"And/or" includes each of the mentioned items and all combinations of one or more of the mentioned items.

The terms used in this specification are to describe the embodiments and are not to limit the present invention. In this specification, singular forms also include plural forms unless specially stated otherwise in the phrases. The terms "comprises" and/or "comprising" used in this specification means that the mentioned components, steps, operations, and/or elements do not exclude the presence or addition of one or more other components, steps, operations and/or elements.

In addition, throughout the specification, when a part is said to be "connected" to another part, this also includes "indirectly" or "electrically connected" cases with intervention of other members or components therebetween, as well as "directly connected" cases.

In addition, throughout the specification, the description that each layer (film), region, pattern, or structure is formed "above/on" or "beneath/under" a substrate, each layer (film), region, pad, or pattern includes both cases that they are formed directly and formed with intervention of other layers. The criteria for being above/on or beneath/under each layer are explained with reference to the drawings.

In addition, expressions such as 'first, second', and the like are only used to distinguish a plurality of components, and do not limit the sequence of the components or other features.

Unless defined otherwise, all the terms (including technical and scientific terms) used in this specification may be used as meanings that can be commonly understood by those skilled in the art. In addition, terms defined in commonly used dictionaries are not interpreted ideally or excessively unless clearly and specifically defined.

Hereinafter, an electronic device including an insulation plate cover according to the present invention will be described with reference to the drawings.

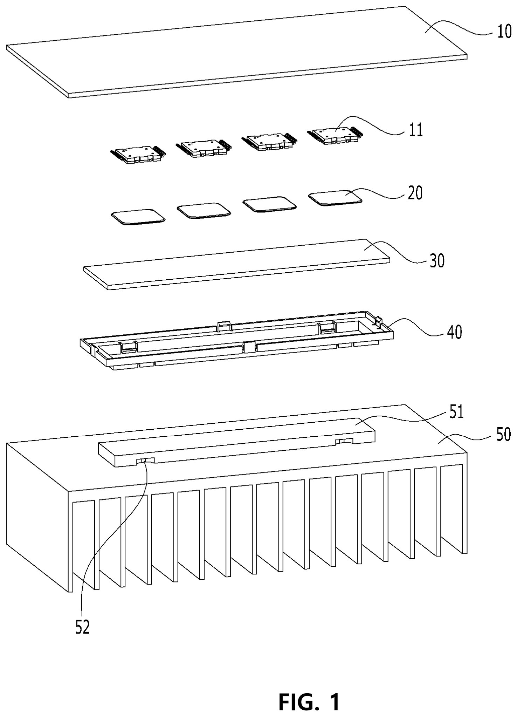

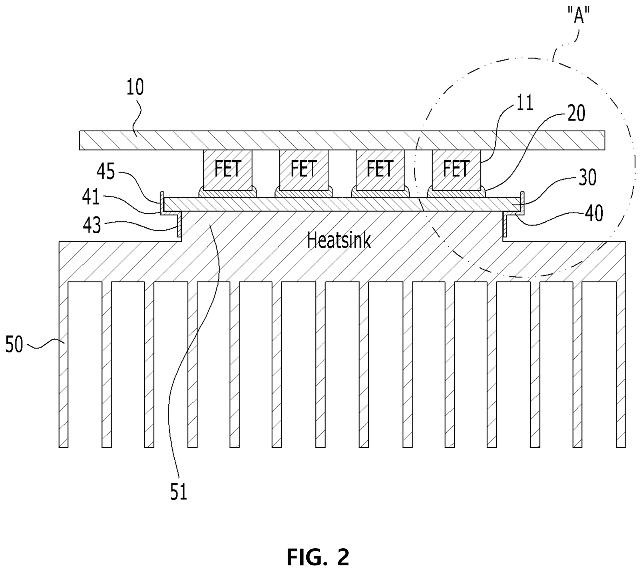

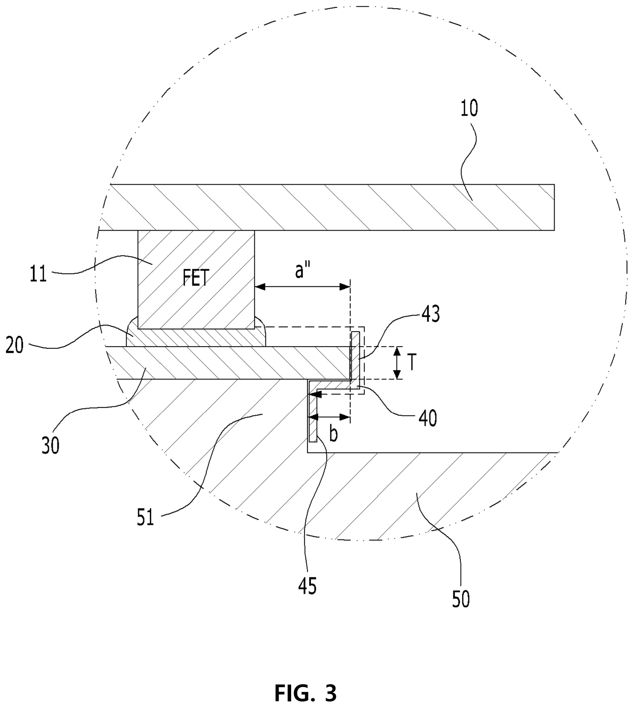

FIGS. 1 and 2 are an exploded perspective view and a cross-sectional view, respectively, of an electronic device including an insulation plate cover according to an embodiment of the present invention, and FIG. 3 is an enlarged cross-sectional view of portion "B" of FIG. 2.

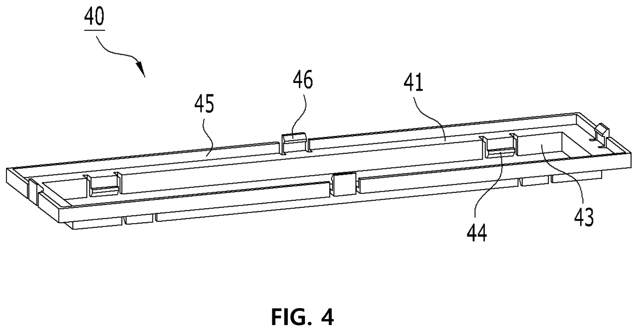

Figure 4 is a perspective view showing an insulation plate cover according to an embodiment of the present invention.

Referring to Figures 1 to 4, an electronic device including an insulation plate cover according to an embodiment of the present invention may include an insulation plate 30 in contact with the semiconductor element 11, a heat sink 50 including a protrusion part 51 protruding in a planar manner and in contact with the insulation plate 30, wherein the insulation plate cover 40 couples the insulation plate 30 and the heat sink 50. The insulation plate cover 40 may include a hollow frame 41, a first wall 43 formed on inner side of the frame 41 to surround the sides of the heat sink protrusion part 51, and a second wall 45 formed on outer side of the frame 41 to surround the sides of the insulation plate 30.

The semiconductor element 11 may be a FET (Field Effect Transistor) used to switch current for power supply in a charging device of an electric vehicle. Power switching components such as FETs generate significant heat, and excessive temperature rise can degrade device performance, making efficient heat dissipation important.

The semiconductor element 11 is soldered to a circuit board 10 of the electronic device and operates by being connected to other circuit components through circuit patterns.

Heat generated by the semiconductor element 11 mounted on the circuit board 10 can be dissipated through a heat sink 50 having high thermal conductivity and a large contact area. In this case, the semiconductor element 11 is connected to the primary-side circuit, and the heat sink 50 is connected to the secondaryside ground terminal, so an insulation distance required by safety standards must be maintained between the semiconductor element 11 and the heat sink 50. However, since the actual distance cannot be sufficiently separated, an insulation plate 30 with equivalent electrical insulating performance is provided.

The insulation plate 30 should have high thermal conductivity while also exhibiting excellent electrical insulation due to a high intrinsic resistance.

Preferably, the insulation plate 30 in the embodiment may be formed of an aluminum oxide (Al₂O₃) ceramic plate.

The aluminum oxide (Al2O3) ceramic plate is made of the ceramic material aluminum oxide (Al2O3) and provides high thermal conductivity of approximately 30 W/m·K, excellent electrical insulation of 18 kV/mm, as well as high heat resistance and superior mechanical strength.

A TIM (Thermal Interface Material) may be provided between the semiconductor element 11 and the insulation plate 30. Due to microscopic surface roughness between the heat-generating element and the heat sink, an air layer is formed, which has low thermal conductivity and hinders heat transfer. The TIM fills this gap, increases thermal conductivity, and efficiently transfers heat to the heat sink.

A preferred embodiment of the TIM may use a thermal paste (thermal grease). Thermal paste is easy to apply and has high thermal conductivity, eliminating gaps between the semiconductor element 11 and the insulation plate 30 to maintain efficient heat transfer.

The heat sink 50 is made of a metal with excellent thermal conductivity, such as aluminum or copper, and may have a fin structure to increase the surface area for efficient heat dissipation into the air.

The heat sink 50 may include a protrusion part 51 that protrudes in a planar manner and contacts the insulation plate 30.

Heat absorbed from the insulation plate 30 at the protrusion part 51 can be dissipated through the surface area of the heat sink 50.

An insulation plate cover 40 for coupling the insulation plate 30 to the heat sink 50 can be secured to the protrusion part 51. The protrusion part 51 may include a hook catch 52 concavely formed on its side, to which a first hook 44 of the insulation plate cover 40 can engage, allowing the insulation plate cover 40 to be coupled to the heat sink 50.

Referring to Figure 4, the insulation plate cover 40 may include a hollow frame 41, a first wall 43 formed on inner side of the frame 41 to surround the sides of the protrusion part 51 of the heat sink 50, and a second wall 45 formed on outer side of the frame 41 to surround the sides of the insulation plate 30.

The first wall 43 is formed by protruding downward in a rib shape from the inner edge of the frame 41, and the protrusion part 51 of the heat sink 50 can be accommodated within the internal space defined by the first wall 43. The second wall 45 is formed by protruding upward in a rib shape from the outer edge of the frame 41, and the insulation plate 30 can be accommodated within the internal space defined by the second wall 45.

The insulation plate cover 40 may further include a plurality of first hooks 44 formed to be engaged with and fixed to sides of the protrusion part 51 at sections where part of the first wall 43 is open, and a plurality of second hooks 46 formed to be engaged with and fixed to an upper surface of the insulation plate 30 at sections where part of the second wall 45 is open.

In the embodiment, the first wall 43 has two long sides and two short sides, with two first hooks 44 formed on each long side, providing a total of four first hooks 44. The second wall 45 has two long sides and two short sides, with one second hook 46 formed on each long and short side, providing a total of four second hooks 46.

The first hooks 44 engage with the hook catches 52 formed on the sides of the protrusion part 51 of the heat sink 50, securing the insulation plate cover 40 to the heat sink 50. The second hooks 46 engage with the top surface of the insulation plate 30, which is surrounded by the second wall 45, securing the insulation plate 30 to the insulation plate cover 40. In this way, the insulation plate cover 40 simultaneously couples the insulation plate 30 and the heat sink 50, so that the insulation plate 30, the insulation plate cover 40, and the heat sink 50 form a single assembly.

At this time, the height of the first wall 43 should be less than the height of the protrusion part 51. If the height of the first wall 43 is greater, then the top surface of the frame 41 of the insulation plate cover 40 will be higher than the top surface of the protrusion part 51, so that the lower surface of the insulation plate 30 does not contact the upper surface of the protrusion 51.

Similarly, the length of the first hook 44 up to its tip should also be less than the height of the protrusion part 51. If the first hook 44 is too long, the top surface of the frame 41 of the insulation plate cover 40 will again be higher than the top surface of the protrusion part 51, so that the bottom surface of the insulation plate 30 does not contact the top surface of the protrusion part 51.

Figure 3 is an enlarged cross-sectional view of portion "A" of Figure 2.

Referring to Figure 3, the distance between the heat sink 50 and the semiconductor element 11, that is, the insulation distance, can be the sum of the distance from the semiconductor element 11 to the outer edge of the insulation plate 30 (a"), the thickness of the insulation plate 30 (T), and the distance from the outer edge of the insulation plate 30 to the outer edge of the protrusion part 51 (b), i.e., a" + T + b.

In the embodiment, the insulation distance is increased by the sum of the thickness of the insulation plate 30 (T) and the distance from the outer edge of the insulation plate 30 to the outer edge of the protrusion part 51 (b), compared to the insulation distance of a conventional electronic device. Therefore, the insulation plate 30 according to the embodiment can satisfy the insulation distance required by safety standards with a size reduced by T + b at each corner compared to a conventional insulation plate 30. In this way, a reduced-size insulation plate 30 can meet the insulation requirements while lowering manufacturing costs.

As described above, according to the electronic device including the insulation plate cover of the present invention, the insulation distance required by safety standards can be met while reducing the size of the insulation plate installed to insulate between the heat sink and the heat-generating element. By reducing the size of the costly insulation plate, manufacturing costs of the electronic device can be lowered, and the utilization of internal space within the device can be improved.

Next, an electronic device including a grounding piece according to the present invention will be described with reference to the drawings.

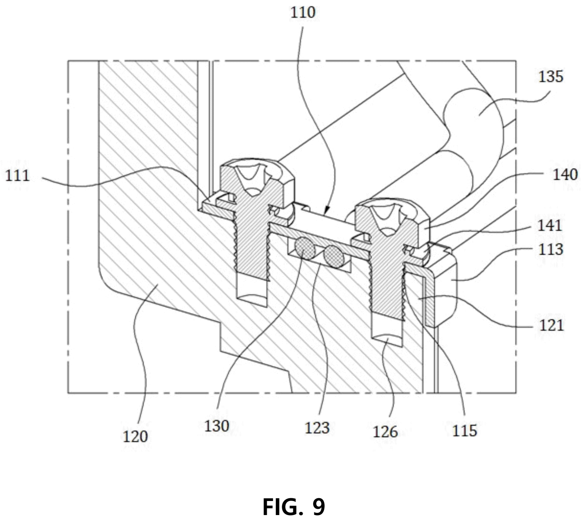

Figures 8 and 9 are an exploded perspective view and a cross-sectional view, respectively, of an electronic device including a grounding piece according to a first embodiment of the present invention.

Referring to Figures 8 and 9, the electronic device including a grounding piece according to the first embodiment of the present invention may include a case 120, a mounting body 121 formed of a conductive metal and protruding in a planar manner from the case 120, and a grounding piece 110 assembled with a bolt 140 on the mounting body 121.

The mounting body 121 may include a mounting groove 123 concavely recessed on the top surface and a tab hole 126 for assembling the bolt 140.

The mounting body 121 of the first embodiment may be integrally formed with the metal case 120. That is, since a portion of the case 120 protrudes in a planar manner to form the mounting body 121, the case 120 and the mounting body 121 can be a single part.

For example, the case 120 may be made of aluminum processed by a diecasting method, in which case the mounting body 121 can be integrally formed with the case 120 as a protruding feature.

To prevent a decrease in conductivity due to the formation of an oxide layer (Al2O3) on the surface of the mounting body 121 made of aluminum, the top surface of the mounting body 121 can be treated for conductivity (e.g., nickel plating) to enhance electrical conductivity.

In the embodiment, the case 120 may constitute the external housing of an electric vehicle charging device that contains a power-switching electronic circuit handling high voltage and large current. In such an electric vehicle charging device, the grounding structure is important to prevent issues such as electric shock caused by leakage current.

The grounding piece 110 may include a plate-shaped flat portion 111 contacting the top surface of the mounting body 121 and a bolt hole 115 through which the bolt 140 passes. By tightening the bolt 140, which passes through the bolt hole 115, into the tab hole 126 formed in the mounting body 121, the grounding piece 110 can be assembled and secured to the top surface of the mounting body 121. In this case, threads may be preformed in the tab hole 126 by tapping.

When the mounting body and the grounding piece are assembled, an insertion opening into which a copper wire is inserted is defined by the mounting groove and the flat plate.

The grounding piece 110 may further include a side reinforcement 113 contacting the side of the mounting body 121. The side reinforcement 113 is formed by bending the edge of the flat portion 111 downward, which can serve as a guide when assembling the grounding piece 110 onto the mounting body 121 and also help maintain a secure and stable attachment of the grounding piece 110.

Since the side reinforcement 113 is not formed on the side of the mounting groove 123 where the copper wire 130 is to be placed, the copper wire 130 can be inserted into the insertion opening formed between the bottom surface of the grounding piece 110 and the mounting groove 123 of the mounting body 121.

The height of the insertion opening is formed to be smaller than the diameter of the copper wire 130, so when the grounding piece 110 is tightened with the bolt 140, the copper wire 130 can be firmly secured in the insertion opening formed between the mounting body 121 and the grounding piece 110.

A washer 141 for preventing loosening may be further included between the bolt 140 and the grounding piece 110.

The washer 141 can prevent the bolt 140 from loosening from the mounting body 121. It may be a flat washer to increase friction by enlarging the contact area, or a spring washer or serrated washer to provide stronger friction using additional elasticity or a rough surface.

By including the washer 141 in this way, loosening of the bolt 140 due to vibration or external impact can be prevented, and the fastening force can be maintained consistently.

The grounding piece 110 is also formed of a conductive metal, enhancing electrical conductivity between the copper wire 130 and the case 120.

In addition, a ground mark may be engraved on the top surface of the flat portion 111 to improve the visibility of the grounding structure, thereby reducing installation errors when setting up the electronic device.

The ground mark may be indicated as "GND" or by the standard earth ground symbol used in circuit diagrams.

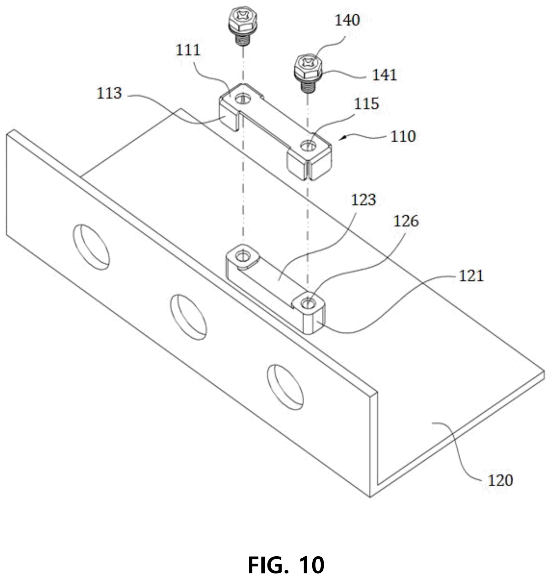

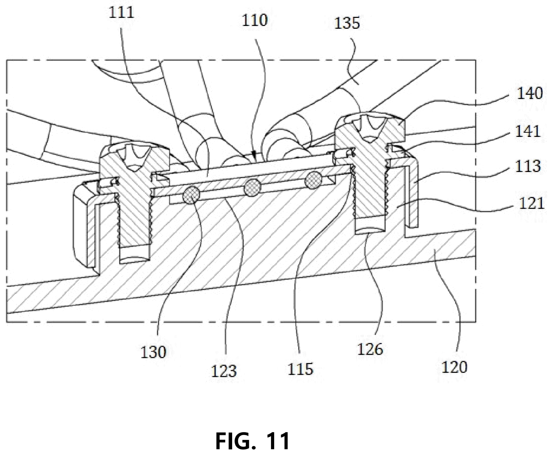

Figures 10 and 11 are an exploded perspective view and a cross-sectional view, respectively, of an electronic device including a grounding piece according to a second embodiment of the present invention.

Referring to Figures 10 and 11, in the second embodiment, the position where the mounting body 121 is formed and a portion of the shape of the side reinforcement 113 of the grounding piece 110 differ from those in the first embodiment.

In the second embodiment, the mounting body 121 is formed fully protruding in a planar manner on the flat surface of the case 120, so that the side reinforcements 113 of the grounding piece 110 covering the mounting body 121 can be formed on all four corners.

In contrast, in the first embodiment, since the mounting body 121 is formed adjacent to the side of the case 120, the side reinforcements 113 of the grounding piece 110 covering the mounting body 121 are formed on only three corners.

In addition, the mounting groove 123 is formed wide enough so that three or more copper wires 130 can be secured in the insertion opening between the grounding piece 110 and the mounting groove 123.

Other structures and shapes are the same as in the first embodiment, and detailed description thereof is omitted.

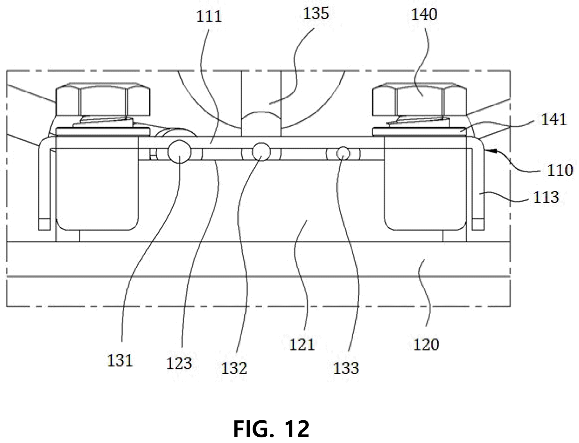

Figure 12 is a cross-sectional view of an electronic device including a grounding piece according to a third embodiment of the present invention.

Referring to Figure 12, in the third embodiment, the diameters of the copper wires 131, 132, and 133 differ from those in the second embodiment. In the third embodiment, the first copper wire 131 has the largest diameter, the second copper wire 132 has a medium diameter, and the third copper wire 133 has the smallest diameter.

The copper wires 131, 132, and 133 may be stranded wires in which multiple single wires are twisted together like a rope. Therefore, if the height of the insertion opening formed between the grounding piece 110 and the mounting groove 123 is smaller than the diameter of the stranded wire, the circular cross-section of the stranded wire can be deformed into an oval shape and compressed.

In this case, the height of the insertion opening is formed smaller than the diameter of the smallest third copper wire 133, so that all of the first copper wire 131, the second copper wire 132, and the third copper wire 133 can be firmly secured in the insertion opening.

Other structures and shapes are the same as in the second embodiment, and detailed description thereof is omitted.

As described above, according to the electronic device including the grounding piece of the present invention, the same grounding connection effect as conventional grounding structures can be achieved with less processing, thereby reducing manufacturing costs for devices employing this structure. In addition, by forming part of the grounding structure using the device case, the grounding structure can be further simplified.

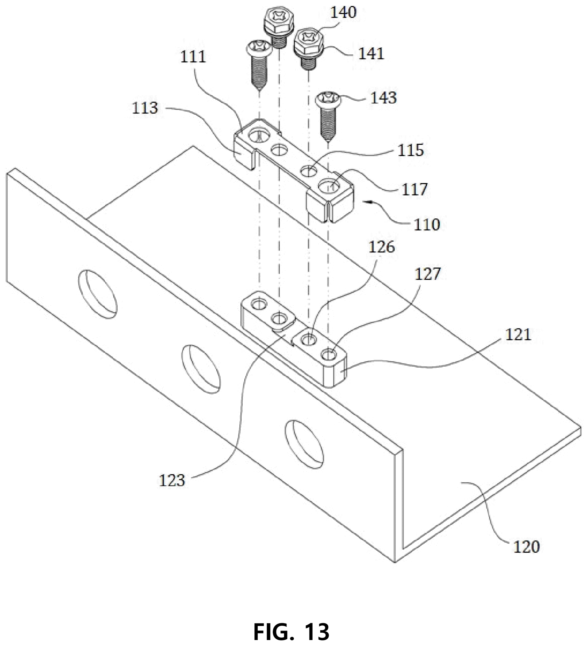

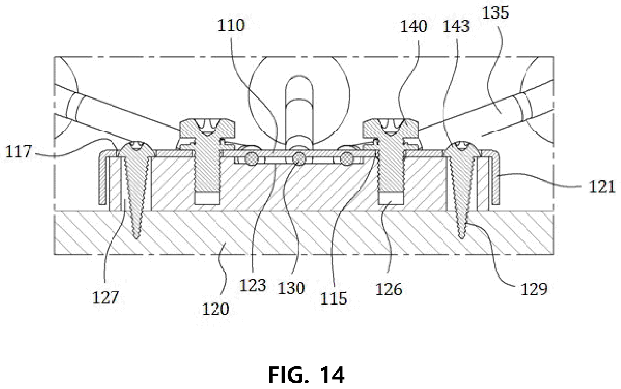

Figures 13 and 14 are an exploded perspective view and a cross-sectional view, respectively, of an electronic device including a grounding piece according to a fourth embodiment of the present invention.

Referring to Figures 13 and 14, unlike the previous embodiments in which the mounting body 121 is integrally formed with the case 120, in the fourth embodiment, the mounting body 121 is formed as a separate component and assembled onto a case 120 made of plastic.

That is, the mounting body 121 according to the fourth embodiment is a separate component, machined from a conductive metal material, and can be assembled onto the plastic case 120.

The mounting body 121 may further include a through-hole 127 for a screw to pass through. By inserting a screw 143 through the through-hole 127 and tightening the screw 143 into a screw hole 129 of the case 120, the mounting body 121 can be assembled and secured onto the case 120. Next, the grounding piece 110 is mounted to cover the mounting body 121, and by fastening the bolt 140, the grounding piece 110 can be assembled and secured on the mounting body 121.

In this case, the grounding piece 110 may include a relief hole 117 to accommodate the head of the screw 143. The relief hole 117 prevents interference from the screw head when the grounding piece 110 is assembled onto the mounting body 121.

Other structures and shapes are the same as in the second embodiment, and detailed description thereof is omitted.

According to the electronic device including the grounding piece of the fourth embodiment, even when the case is formed by plastic molding, the mounting body can be pre-machined and assembled onto the case, allowing the use of the same grounding piece as in other embodiments and thereby reducing manufacturing costs.

Although the present invention has been described as described above, those skilled in the art will recognize that the present invention may be implemented in other forms while maintaining the technical ideas and essential features of the present invention.

Although the scope of right of the present invention will be determined basically by the patent claims, it should be interpreted that all changes or modified forms derived from equivalent configurations, as well as the configurations directly derived from the description of the patent claims, are included in the scope of right of the present invention.

## Claims

1. An electronic device including an insulation plate cover for a heatdissipating structure that releases heat generated by a semiconductor element, the device comprising:
an insulation plate in contact with the semiconductor element;
a heat sink including a protrusion part protruding in a planar manner and in contact with the insulation plate; and
an insulation plate cover coupling the insulation plate and the heat sink,
**characterized in that**
the insulation plate cover includes a hollow frame,
a first wall formed on inner side of the frame to surround sides of the protrusion part of the heat sink, and
a second wall formed on outer side of the frame to surround sides of the insulation plate.

2. The electronic device according to claim 1, **characterized in that** the insulation plate cover further comprises a plurality of first hooks formed at sections where part of the first wall is open, and configured to be engaged with and fixed to a side surface of the protrusion part, and a plurality of second hooks formed at sections where part of the second wall is open, and configured to be engaged with and fixed to an upper surface of the insulation plate.

3. The electronic device according to claim 2, **characterized in that** a height of the first wall is smaller than a height of the protrusion part.

4. The electronic device according to claim 2, **characterized in that** a length of each of the first hooks up to a tip thereof is smaller than a height of the protrusion part.

5. The electronic device according to claim 3, **characterized in that** the protrusion part includes a hook catch concavely formed inward on a side surface thereof.

6. The electronic device according to claim 1, **characterized in that** an insulation distance between the semiconductor element and the heat sink is a sum of a distance from the semiconductor element to an outer edge of the insulation plate, a thickness of the insulation plate, and a distance from the outer edge of the insulation plate to an outer edge of the protrusion part.

7. The electronic device according to claim 1, **characterized in that** the insulation plate is formed of an aluminum oxide (Al₂O₃) ceramic plate.

8. The electronic device according to claim 1, **characterized in that** a thermal interface material (TIM) in the form of thermal paste is provided between the semiconductor element and the insulation plate.

9. An electronic device comprising:
a case;
a mounting body formed of a conductive metal and protruding from the case; and
a grounding piece assembled on the mounting body with a bolt,
**characterized in that**
the mounting body includes a mounting groove recessed concavely in an upper surface thereof and a tap-hole into which the bolt is assembled,
the grounding piece includes a flat plate contacting the upper surface of the mounting body and a bolt hole through which the bolt passes,
wherein, when the mounting body and the grounding piece are assembled, an insertion opening into which a copper wire is inserted is defined by the mounting groove and the flat plate, and
a height of the insertion opening is smaller than a diameter of the copper wire.

10. The electronic device according to claim 9, **characterized in that** the mounting body is integrally formed with the metal case.

11. The electronic device according to claim 9, **characterized in that** the grounding piece further comprises a side reinforcement contacting a side of the mounting body, and the side reinforcement is not provided on a side of the mounting groove.

12. The electronic device according to claim 9, **characterized in that** the copper wires are two or more and have different diameters.

13. The electronic device according to claim 9, **characterized in that** the mounting body is a separate component, machined independently and assembled onto the plastic case.

14. The electronic device according to claim 9, **characterized in that** the mounting body further includes a through-hole for receiving a screw.

15. The electronic device according to claim 9, **characterized in that** the grounding piece further includes a relief hole configured to accommodate a head of the screw.
